# EUROPEAN PATENT APPLICATION

(11) **EP 3 296 427 A1**
(43) Date of publication of application: **21.03.2018**
(21) Application number: 16796384.2
(22) Date of filing: 12.05.2016
(51) Int. Cl.: C23C 16/27, B23B 27/14, B23B 27/20, C01B 31/06, C23C 16/01, F16C 33/12

(54) **SLIDING FILM, METHOD FOR PRODUCING SAME, SLIDING MEMBER, AND METHOD FOR PRODUCING SAME**

(30) Priority: 15.05.2015 JP 2015099902
(71) Applicant: Eagle Industry Co., Ltd., Minato-ku Tokyo 105-8587 (JP)
(72) Inventor: OKA Masao, Tokyo 105-8587 (JP)
(74) Representative: WSL Patentanwälte Partnerschaft mbB
(86) International application number: PCT/JP2016/064093
(87) International publication number: WO 2016/185991

(57) **Abstract**

Provided are a sliding film that has desired surface roughness and surface shape and contains a hard carbon material as a main component, a method of producing the sliding film, a sliding member, and a method of producing the sliding member. A diamond film 20 has a smooth transfer surface 21. The transfer surface 21 is a sliding surface 21. A sliding member 50 includes an adhesive layer 40 for bonding the diamond film 20 on a base 30. The deposited diamond film 20 is removed from a substrate 10. The transfer surface 21 on the side of the substrate 10 of the diamond film 20 is set as the sliding surface 21. A deposited surface 22 opposite to the transfer surface 21 is attached and fixed onto the base 30 via the adhesive 40.

## Description

### {TECHNICAL FIELD}

The present invention relates to a sliding film for use in machine elements that operate with sliding movements, such as bearings, seals, dies, and cutting tools, a method of producing the sliding film, a sliding member, and a method of producing the sliding member.

### {BACKGROUND ART}

Conventionally, bearings and seals for rotary machines, such as pumps and turbines, and for linear motion machines, such as hydraulic cylinders, dies used for forming, and cutting tools, such as tool bits, have sliding parts that relatively move in contact with and between a stationary member and a movable member or between movable members.

From a viewpoint of downsizing, wear, lifetime, and the like of devices and equipment, a sliding member with excellent wear resistance is used in the above-mentioned sliding part. In some of the sliding members, a coating with excellent wear resistance is formed on a surface of a base of the sliding member. A diamond film, which has excellent wear resistance, is adopted as the coating in some cases (see, for example, Patent Citations 1, 2, and 3).

### {CITATION LIST}

### {Patent Literature}

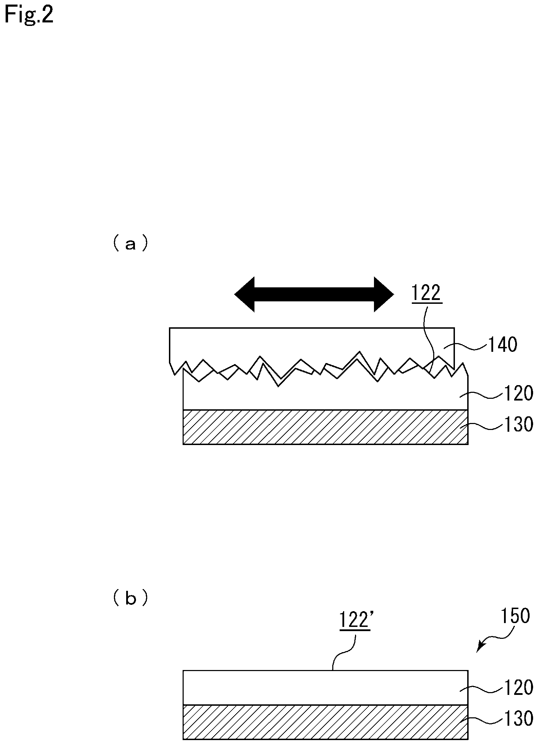

Patent Citation 1: JP H2(1990)-300569 A (Page 3, lower left column, lines 7-10, FIG. 2)
Patent Citation 2: JP 2011-505532 A ([0007])
Patent Citation 3: JP 2006-275286 A ([0014])

### {SUMMARY OF INVENTION}

### {Technical Problem}

In general, the diamond film in a deposited state has a rough surface, and thus its surface is polished to be made smooth. However, the diamond film itself is hard and requires much time to be polished. For this reason, Patent Citation 3 has proposed that a diamond film is further coated with a hard carbon film as an upper layer, which has a lower hardness than a diamond film, and that the carbon film is polished. Nevertheless, as the technique described in Patent Citation 3 needs to coat the diamond film with hard carbon as the upper layer, those two layers must be deposited and polished, and additionally, the formation of a surface profile of a sliding surface becomes complicated. Further, since the diamond film is deposited by epitaxial growth on a base that forms a structure body of the sliding member, the range of choices for the base on which the diamond film is deposited becomes limited.

The present invention has been made in view of the foregoing problems, and it is an object of the present invention to provide a sliding film that contains a hard carbon material with desired surface roughness and surface shape, as a main component, and a method of producing the sliding film.

Further, it is another object of the present invention to provide a sliding member that can be obtained by forming the sliding film containing a hard carbon material as a main component, on various kinds of bases, and a method of producing the sliding member.

### {Solution to Problem}

### (A1 aspect)

A sliding film according to an A1 aspect of the present invention has a smooth transfer surface, the transfer surface being a sliding surface, the sliding film containing a hard carbon material as a main component.

According to the A1 aspect, since the sliding surface is the transfer surface, the accuracy of the surface roughness and surface shape of the sliding surface of the sliding film, which contains the hard carbon material as the main component, is high.

### (A2 aspect)

In the A1 aspect, the hard carbon material is diamond.

According to the A2 aspect, the accuracy of the surface roughness and surface shape of the sliding surface is high even in the diamond, which is hard and difficult to process.

### (A3 aspect)

In the A1 aspect or the A2 aspect, a roughness of a surface opposite to the sliding surface is larger than a roughness of the sliding surface before use.

According to the A3 aspect, since the smooth surface is set as the sliding surface, the need for a process, such as lapping, can be eliminated or lessened.

### (B1 aspect)

A method of producing a sliding film according to a B1 aspect of the present invention includes the steps of:
depositing a sliding film on a smooth surface of a substrate, the sliding film containing a hard carbon material as a main component; and
removing the sliding film, deposited in the deposition step, from the substrate.

According to the B1 aspect, since the smooth surface of the substrate is transferred to the sliding film, the accuracy of the surface roughness and surface shape of the transferred sliding surface is high.

### (B2 aspect)

In the B1 aspect, in the removing step, the sliding film is removed by dissolving the substrate.

According to the B2 aspect, the surface of the substrate is accurately transferred to the sliding film.

### (B3 aspect)

In the B1 aspect or the B2 aspect, at least one of a convex part and a concave part is formed in the substrate.

According to the B3 aspect, a concave part or a convex part, corresponding to the convex part or the concave part of the substrate, can be formed easily in the sliding film.

### (B4 aspect)

In any one of the B1 to B3 aspects, the hard carbon material is diamond.

According to the B4 aspect, the accuracy of the surface roughness and surface shape of the sliding surface is high even in the diamond, which is hard and difficult to process.

### (B5 aspect)

In any one of the B1 to B4 aspects, a roughness of a surface of the sliding film opposite to the substrate is larger than a roughness of the surface of the substrate.

According to the B5 aspect, since the surface of the sliding film opposite to the substrate may be rough, the film deposition rate can be enhanced.

### (C1 aspect)

A sliding member according to a C1 aspect of the present invention includes:
a base;
a sliding film having a sliding surface and containing a hard carbon material as a main component; and
an adhesive layer for bonding the sliding film to the base.

According to the C1 aspect, since the sliding film is fixed to the base by bonding with the adhesive layer, there is a wide range of choices for the material of the base to which the sliding film is fixed.

### (C2 aspect)

In the C1 aspect, the hard carbon material is diamond.

According to the C2 aspect, the sliding film can be fixed, regardless of the material of the substrate on which the diamond is deposited. Thus, there is a wide range of choices for the material of the base.

### (C3 aspect)

In the C1 aspect or the C2 aspect, a surface roughness, on a side of the adhesive layer, of the sliding film is larger than a surface roughness, on a side of the sliding surface, of the sliding film.

According to the C3 aspect, the sliding film has a wide surface area in contact with the adhesive layer, so that the sliding film can be firmly fixed to the base.

### (C4 aspect)

In any one of the C1 to C3 aspects, the sliding surface is a transfer surface.

According to the C4 aspect, since the sliding surface is the transfer surface, the accuracy of surface roughness and surface shape of the sliding surface is high.

### (C5 aspect)

In any one of the C1 to C4 aspects, the adhesive layer has a smaller Young's modulus than each of the base and the sliding film in a state where the adhesive layer bonds and fixes the base and the sliding film.

According to the C5 aspect, during sliding, the adhesive layer serves as the so-called buffer material, thereby making it possible to reduce the influence of a force acting between the base and the sliding film.

### (D1 Aspect)

A method of producing a sliding member according to a D1 aspect includes the steps of:
removing a sliding film deposited in a deposition step from a substrate, the sliding film containing a hard carbon material as a main component; and
bonding the sliding film removed in the removing step, to a base.

According to the D1 aspect, since the sliding film is bonded to the base, there is a wide range of choices for the material of the base to which the sliding film is fixed.

### (D2 aspect)

In the D1 aspect, in the deposition step, the sliding film containing the hard carbon material as a main component is deposited on a smooth surface of the substrate.

According to the D2 aspect, since the smooth surface of the substrate is transferred to the sliding film, the accuracy of the surface roughness and surface shape of the transferred sliding surface is high.

### (D3 aspect)

In the D1 aspect or the D2 aspect, in the removing step, the sliding film is removed by dissolving the substrate.

According to the D3 aspect, the surface of the substrate is accurately transferred to the sliding film.

### (D4 aspect)

In any one of the D1 to D3 aspects, at least one of a convex part and a concave part is formed in the substrate.

According to the D4 aspect, a concave part or a convex part, corresponding to the convex part or the concave part of the substrate, can be formed easily in the sliding film.

### (D5 aspect)

In any one of the D1 to D4 aspects, the hard carbon material is diamond.

According to the D5 aspect, the accuracy of the surface roughness and surface shape of the sliding surface is high even in the diamond, which is hard and difficult to process.

### (D6 aspect)

In any one of the D1 to D5 aspects, a roughness of a surface of the sliding film opposite to the substrate is larger than a roughness of the surface of the substrate.

According to the D6 aspect, since the surface of the sliding film opposite to the substrate may be rough, the film deposition rate can be enhanced.

### {BRIEF DESCRIPTION OF DRAWINGS}

FIGS. 1A to 1E are cross-sectional views showing a first embodiment of a sliding member and a method of producing the sliding member according to the present invention, in which FIG. 1A is a cross-sectional view of a substrate, FIG. 1B is a cross-sectional view showing a state of a diamond film deposited on the substrate, FIG. 1C is a cross-sectional view showing a state of the diamond film removed from the substrate, FIG. 1D is a cross-sectional view showing a state in which the diamond film is bonded to the base, and FIG. 1E is a cross-sectional view of a sliding member.

FIGS. 2A and 2B are reference cross-sectional views showing a state of polishing a sliding surface, in which FIG. 2A is a cross-sectional view of a state of polishing by co-grinding, and FIG. 2B is a cross-sectional view of the sliding member polished.

FIGS. 3A to 3E are cross-sectional views showing a second embodiment of a sliding member and a method of producing the sliding member according to the present invention, in which FIG. 3A is a cross-sectional view of a substrate, FIG. 3B is a cross-sectional view showing a state of a diamond film deposited on the substrate, FIG. 3C is a cross-sectional view showing a state of the diamond film removed from the substrate, FIG. 3D is a cross-sectional view showing a state in which the diamond film is bonded to the base, and FIG. 3E is a cross-sectional view of a sliding member.

FIGS. 4A and 4B are reference cross-sectional views showing a recessed groove formed in the sliding surface by laser machining, in which FIG. 4A is a cross-sectional view showing a state of laser machining, and FIG. 4B is a cross-sectional view of a sliding member subjected to the laser machining.

FIG. 5 is a cross-sectional view showing a third embodiment of a sliding member according to the present invention.

### {DESCRIPTION OF EMBODIMENTS}

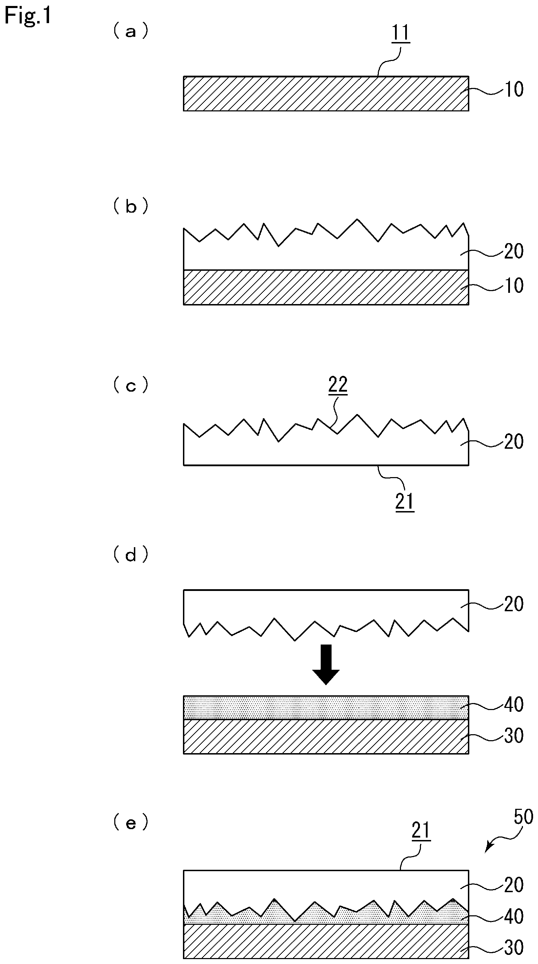

Modes for carrying out a sliding film, a method of producing the sliding film, a sliding member and a method of producing the sliding member according to the present invention will be described below based on embodiments. In the following description, the terms up, down, right, and left will be defined as the upward, downward, rightward, and leftward directions on the plane of the paper of FIGS. 1A to 1E.

The sliding film is a film deposited using a hard carbon material as a main component. Examples of the hard carbon material include diamond as a crystal made of SP³ bonded carbon, a Diamond-Like Carbon (DLC) mainly made of an amorphous SP³ bonded carbon, etc. In the description below, a diamond film deposited using a diamond as a main component, which is physically and chemically more stable, will be explained by way of example.

Here, the method of producing the diamond film is not particularly limited, but a high-pressure synthesis method, a vapor-phase synthesis method, and the like are known. In terms of its deposition, the vapor-phase synthesis method is preferable. Examples of the vapor-phase synthesis method suitable for use can include plasma CVD, thermal filament CVD, and microwave plasma CVD, etc.

The substrate on which the diamond film is grown is made using Si (silicon), SiC (silicon carbide), or WC (tungsten carbide). On the substrate, diamond is formed by heteroepitaxial growth and further by polycrystalline growth with high orientation. When using these kinds of substrates, the substrate is desirably subjected to pretreatment, such as scratching, a bias electric field, and a seeding treatment, as is well-known.

Note that a single crystalline diamond may be used as the substrate, and then on this substrate, diamond may be formed by homoepitaxial growth.

Gas containing carbon and preferably gas obtained by diluting methane with hydrogen can be used as raw material gas. A small amount of oxygen, carbon monoxide and carbon dioxide may be added to the raw material gas as needed. The raw material gas is decomposed by plasma, heat, or the like, and active species in the gas phase and the like, created from the raw material gas, are crystallized on a heated substrate, thereby depositing a diamond film. Hydrogen atoms, created and dissociated from the raw material gas, act to etch carbon in the non-diamond structure, whereby only a diamond phase is obtained.

### First embodiment

In the following, the first embodiment will be described with reference to FIGS. 1A to 1E.

### <Step (a)>

A substrate 10 made of SiC and having a predetermined flat surface 11 is prepared.

### <Step (b)>

Diamond is heteroepitaxially grown from the raw material gas by the thermal CVD, whereby a diamond film 20 is deposited on the flat surface 11 of the substrate 10.

### <Step (c)>

After the deposition, the substrate 10 or its surface is dissolved by dry etching using fluorine-based etching gas, thereby removing the diamond film 20 from the substrate 10.

### <Step (d)>

An adhesive 40 (adhesive layer) is applied onto a base 30, which configures a structure body of a sliding member 50. The diamond film 20 is then turned upside down and then attached onto the adhesive 40 by pressing a deposited surface 22, which is positioned as an upper surface during the deposition, toward the lower side, i.e., toward the side of the base 30.

### <Step (e)>

The sliding member 50 that has a sliding surface 21 (transfer surface 21) formed by transfer can be obtained.

In step (a), the flat surface 11 is a smooth surface. The smoothness of the surface is defined by surface roughness, including Rmax (maximum height), Rz (ten-point average roughness), Ra (center line average roughness), in conformity with JIS 0601-1976. In the first embodiment, the predetermined flat surface 11 has a smooth surface. For example, the smooth surface is defined as a surface with an Ra of 1.6a or less. In step (c), the transfer surface 21 as the lower surface of the diamond film 20, removed from the substrate 10, is one to which the flat surface 11 of the substrate 10 is transferred. Thus, the Ra of the transfer surface is substantially equal to the Ra of the flat surface 11, i.e., 1.6a. Meanwhile, in the diamond film 20, a deposited surface 22 as the upper surface thereof is much rougher than the transfer surface 21. Note that for convenience of explanation, in FIGS. 1A to 1E, the surface of the deposited surface 22 is drawn exaggeratedly. Further, means for removing the diamond film 20 from the substrate 10 may also be means other than dry etching, for example, means for physically peeling off the diamond film. Note that for dry etching or wet etching, an etchant that can dissolve only the substrate 10 without dissolving the diamond film 20 is preferably used.

Further, the adhesive 40 for use in step (d) is one that has a smaller Young's modulus than each of the base 30 and the diamond film 20 in a state where the adhesive 40 bonds and fixes the diamond film 20 to the base 30 in step (e) (in a state where the adhesive 40 is being hardened). Moreover, the structure body is a member that configures a machine element of a machine and equipment, for example, like a housing and a rotary shaft. The base 30 configures a part of the structure body.

As mentioned above, since in the diamond film 20, the sliding surface 21 is the transfer surface 21, the sliding surface 21 has high accuracy for the surface roughness and surface shape. Because of this, even when using the diamond film 20 that contains, as a main component, diamond which is hard and difficult to process, the accuracy of the surface roughness and surface shape of the diamond film is high.

Furthermore, before the use, the roughness of the deposited surface 22, positioned on the opposite side to the sliding surface 21, is larger than the roughness of the sliding surface 21. That is, since the smooth surface is set as the sliding surface 21, the need for a process, such as lapping, can be eliminated or lessened. That is, as shown in FIGS. 2A and 2B, the present embodiment can eliminate or lessen the need for a process of producing a conventional sliding member 150, i.e., a process of forming a flat sliding surface 122' by co-grinding and polishing the deposited surface 122 of the diamond film 120 deposited on a substrate 130 as a base by use of a polishing diamond film 140.

Since the diamond film 20 is fixed to the base 30 by bonding with the adhesive 40, as long as the base is made of a material that enables bonding of the diamond film by the adhesive 40, the diamond film can be fixed to the base. There is a wide range of choices for the material of the base 30 to which the diamond film 20 is fixed. In other words, the diamond film 20 can be fixed, regardless of the material of the substrate 10 on which the diamond film 20 is deposited. Note that the diamond film 20 to be bonded to the base 30 may be formed at one or a plurality of members in the surface direction of the base 30. The diamond film 20 can be formed over the plurality of members, thereby easily forming a sliding surface with a wider area.

Further, in the diamond film 20, the roughness of the deposited surface 22 on the side of the adhesive 40 is larger than the surface roughness of the sliding surface 21, and the deposited surface 22 has a wide surface area that is in contact with the adhesive 40. Thus, the diamond film 20 can be firmly fixed to the base 30. Moreover, the deposited surface 22 on the side of the adhesive 40 may be rough, thereby making it possible to enhance a film deposition rate. Meanwhile, since the sliding surface 21 is the transfer surface 21, the accuracy for the surface roughness and surface shape becomes high.

Furthermore, the adhesive 40 has a smaller Young's modulus than each of the base 30 and the diamond film 20 in a state where the adhesive 40 bonds and fixes the base 30 and the diamond film 20. Thus, during sliding operation, an intermediate layer which is made of the adhesive 40 serves as the so-called buffer material. That is, even when the base 30 is deformed by thermal expansion, the intermediate layer of the adhesive 40 can act as the buffer to reduce the influence of a force acting between the base 30 and the diamond film 20.

### Second embodiment

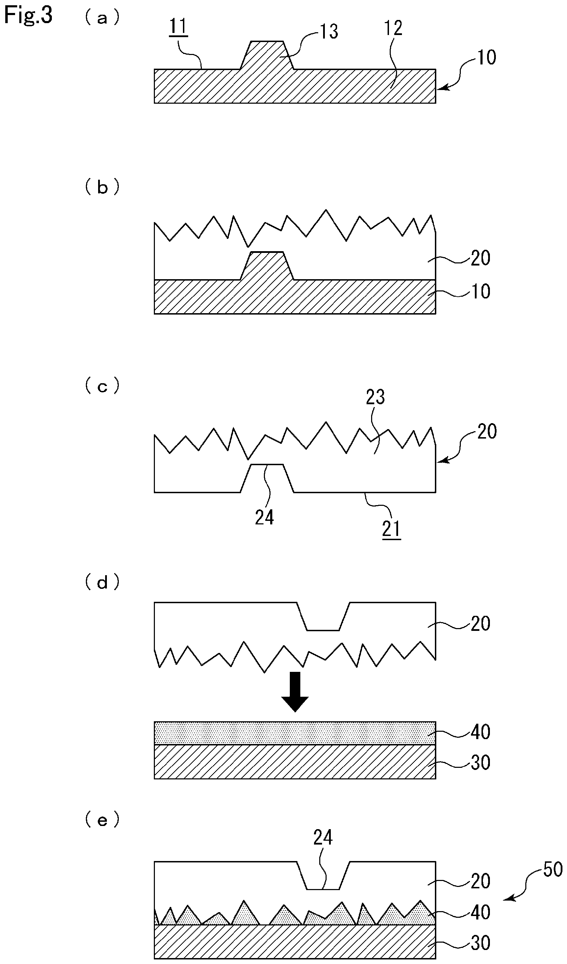

Next, a sliding member representative of the second embodiment will be described with reference to FIGS. 3A to 3E. The second embodiment differs from the first embodiment mainly in that a concave part is provided in the sliding surface 21. Note that the description of the configuration in the second embodiment that is the same as and overlaps with that in the first embodiment will be omitted.

As shown in FIGS. 3A to 3E, a convex part 13 with a trapezoidal cross section is formed in the substrate 10 to protrude upward from the flat surface 11 of a base part 12. The diamond film 20 is deposited on the substrate 10, whereby a concave part 24 is formed along the shape of the convex part 13 on the side of the transfer surface 21 (sliding surface 21) of the diamond film 20. In this way, the concave part 24 can be provided to impart a specific function (for example, a function of holding a lubricant) to the sliding surface 21. It is preferred that the depth of the concave part 24 is shallower (shorter) than the thickness of a base part 23 of the diamond film 20 because the mechanical strength of the diamond film 20 can be ensured.

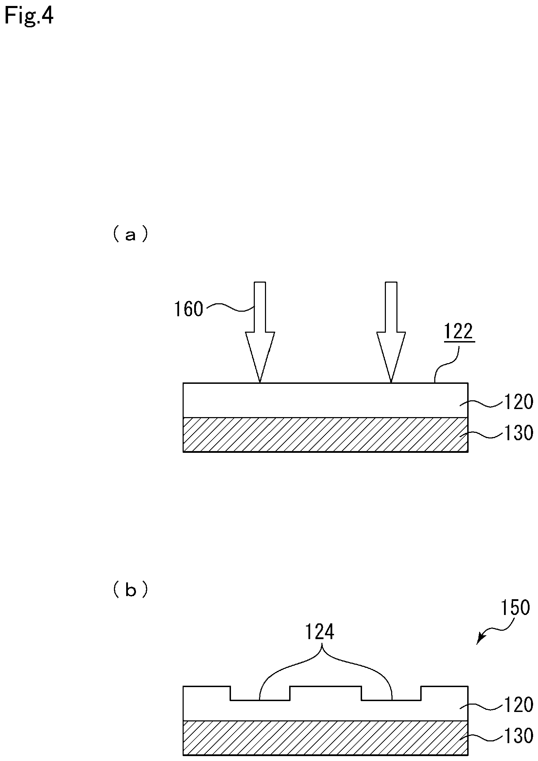

As mentioned above, the convex part 13 is formed in the substrate 10, and the concave part 24 is formed by transferring the convex part 13 to the diamond film 20, so that the concave part 24 with a desired shape can be easily formed. That is, as shown in FIGS. 4A and 4B, the present embodiment can eliminate the need for a process of producing the conventional sliding member 150, i.e., a process of forming a concave part 124 by applying laser irradiation 160 to a deposited surface 122 of a diamond film 120, deposited on the substrate 130 as the base.

As an example it has been described above that the convex part 13 is formed in the substrate 10, and then the concave part 24 is transferred to the diamond film 20. However, a concave part may be formed in the substrate 10, and then a convex part may be formed in the diamond film 20, thereby imparting another specific function to the sliding surface 21. Further, both the convex part and the concave part may be provided to impart other specific functions to the sliding surface.

### Third embodiment

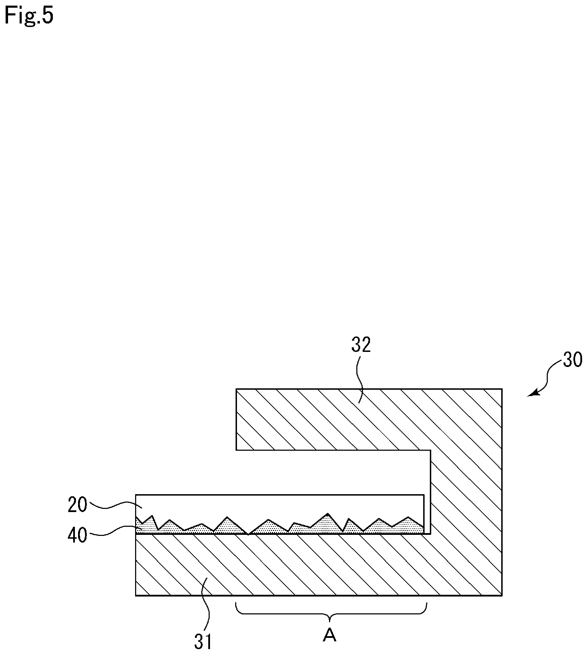

Next, a sliding member representative of the third embodiment will be described with reference to FIG. 5. The third embodiment differs from the first embodiment mainly in the shape of the base 30 at which the diamond film 20 is provided. Note that the description of the configuration in the third embodiment that is the same as and overlaps with that in the first embodiment will be omitted.

As shown in FIG. 5, the base 30 has a substantially inverted J-shaped cross section in which a long-side part 31 and a short-side part 32 are coupled together. The diamond film 20 is attached along and fixed to the upper surface of the long-side part 31. In this way, the diamond film 20 is attached and fixed to the base 30 with the adhesive 40, so that the diamond film 20 can be disposed in a concave space formed by the long-side part 31 and the short-side part 32. That is, when the diamond film 20 is intended to be formed by deposition directly on the upper surface of the long-side part 31, the diamond film 20 cannot be deposited in a region A because it is blocked by the short-side part 32. However, since the diamond film 20 is attached to the base 30 by the adhesive 40, the diamond film 20 can also be provided in the region A, which leads to a high degree of flexibility in the shape of the base 30.

The embodiments of the present invention have been described above with reference to the accompanying drawings. However, specific configurations are not limited to these embodiments and various modifications and additions can be made to be included in the present invention without departing from the gist of the present invention.

Although in the above-mentioned embodiments, the surface of a part of the base 30 where the diamond film 20 is attached is flat by way of example, the surface may be curved. In this case, when attaching the flat-shaped diamond film 20 to the base 30, the diamond film 20 may be attached by being deformed along the surface of the base 30. Alternatively, a curved diamond film 20 is obtained by depositing on a curved substrate 10, which has the shape along the surface of the base 30, and then the curved diamond film 20 may be attached and fixed to the surface of the base 30. In the former case, since the diamond film 20 has the flat shape, the manufacture of the diamond film 20 is easy. Meanwhile, in the latter case, since the diamond film 20 is not deformed, no internal stress occurs substantially in the diamond film 20 attached and fixed to the base 30, which is preferable.

### {REFERENCE SIGNS LIST}

- 10: Substrate
- 11: Flat surface
- 13: Convex part
- 20: Diamond film (Sliding film)
- 21: Transfer surface, sliding surface
- 22: Deposited surface
- 24: Concave part
- 30: Base
- 40: Adhesive (Adhesive layer)
- 50: Sliding member

## Claims

1. A sliding film, **characterizing by** having a smooth transfer surface, the transfer surface being a sliding surface, the sliding film containing a hard carbon material as a main component.

2. The sliding film according to claim 1, **characterized in that** the hard carbon material is diamond.

3. The sliding film according to claim 1 or 2, **characterized in that** a roughness of a surface opposite to the sliding surface is larger than a roughness of the sliding surface before use.

4. A method of producing a sliding film, **characterized by** comprising the steps of:
depositing a sliding film on a smooth surface of a substrate, the sliding film containing a hard carbon material as a main component; and
removing the sliding film, deposited in the deposition step, from the substrate.

5. The method of producing a sliding film according to claim 4, **characterized in that**, in the removing step, the sliding film is removed by dissolving the substrate.

6. The method of producing a sliding film according to claim 4 or 5, **characterized in that** at least one of a convex part and a concave part is formed in the substrate.

7. The method of producing a sliding film according to any one of claims 4 to 6, **characterized in that** the hard carbon material is diamond.

8. The method of producing a sliding film according to any one of claims 4 to 7, **characterized in that** a roughness of a surface of the sliding film opposite to the substrate is larger than a roughness of the surface of the substrate.

9. A sliding member, **characterized by** comprising:
a base;
a sliding film having a sliding surface and containing a hard carbon material as a main component; and
an adhesive layer for bonding the sliding film to the base.

10. The sliding member according to claim 9, **characterized in that** the hard carbon material is diamond.

11. The sliding member according to claim 9 or 10, **characterized in that** a surface roughness, on a side of the adhesive layer, of the sliding film is larger than a surface roughness, on a side of the sliding surface, of the sliding film.

12. The sliding member according to any one of claims 9 to 11, **characterized in that** the sliding surface is a transfer surface.

13. The sliding member according to any one of claims 9 to 12, **characterized in that** the adhesive layer has a smaller Young's modulus than each of the base and the sliding film in a state where the adhesive layer bonds and fixes the base and the sliding film.

14. A method of producing a sliding member, **characterized by** comprising the steps of:
removing a sliding film deposited in a deposition step from a substrate, the sliding film containing a hard carbon material as a main component; and
bonding the sliding film removed in the removing step to a base.

15. The method of producing a sliding member according to claim 14, **characterized in that** in the deposition step, the sliding film containing the hard carbon material as the main component is deposited on a smooth surface of the substrate.

16. The method of producing a sliding member according to claim 14 or 15, **characterized in that** in the removing step, the sliding film is removed by dissolving the substrate.

17. The method of producing a sliding member according to any one of claims 14 to 16, **characterized in that** at least one of a convex part and a concave part is formed in the substrate.

18. The method of producing a sliding member according to any one of claim 14 to 17, **characterized in that** the hard carbon material is diamond.

19. The method of producing a sliding member according to any one of claims 14 to 18, **characterized in that** a roughness of a surface of the sliding film opposite to the substrate is larger than a roughness of the surface of the substrate.
